# EUROPEAN PATENT SPECIFICATION

(11) **EP 0 469 101 B1**
(45) Date of publication and mention of the grant of the patent: **15.04.1998**
(21) Application number: 91902365.5
(22) Date of filing: 25.01.1991
(51) Int. Cl.: H03G 3/20

(54) **POWER AMPLIFIER**
LEISTUNGSVERSTÄRKER
AMPLIFICATEUR DE PUISSANCE

(30) Priority: 17.02.1990 GB 9003663
(43) Date of publication of application: 05.02.1992
(73) Proprietor: MOTOROLA, INC., Schaumburg, IL 60196 (US)
(72) Inventor: JENSEN, Ole, Hedevang, DK-2200 Kobenhavn N (DK)
(74) Representative: Lupton, Frederick
(86) International application number: EP9100146
(87) International publication number: WO9112661

(56) References cited:
- EP-A- 0 369 135
- EP-A- 0 407 135
- CH-A- 638 935
- GB-A- 2 220 808
- U. Tietze; Ch. Schenk: "Halbleiter-Schaltungstechnik" 1980, Springer-Verlag Berlin, Berlin see page 484, last paragraph - page 490, last paragraph; figures 19.48-19.50
- RUNDFUNKTECHNISCHE MITTEILUNGEN. vol. 24, no. 1, January 1980, NORDERSTEDT DE pages 19 - 25; "Entwicklung eines Sendebegrenzers in PCM-Technik" see page 23, left-hand column, paragraph 2 right-hand column, paragraph 1; figure 6

## Description

This invention relates to power amplifiers, such as pulsed power amplifiers, for amplifying radio frequency signals. This invention particularly relates to power amplifiers for use in GSM radio transmitters.

A pulsed power amplifier which may be used in GSM mobile radio transmitters is described in UK patent application no. 8826918.8, the disclosure of which is incorporated herein by reference. This application discloses a burst modulated power amplifier whose output power characteristics upon turn-on and turn-off are controlled by power control signals which are dependent on a sequence of values stored in a memory of a power control section of the power amplifier. The power amplifier can operate at a number of different output power levels and a sequence of values is stored in the memory for each of these power levels. Once a power level has been selected, the corresponding sequence of values is selected and read from the memory.

The output power of a GSM mobile radio transmitter must be adjustable between sixteen power levels. In order to account for tolerance factors within the amplifier which will affect the ultimate output power, there are generally sixteen nominal power levels which are each split into four sub-levels close to the nominal value. A transmit controller of the power control section can then determine which of the sixty-four sub-levels is best to represent each one of the sixteen nominal power levels. There are therefore sixty-four sequences of values stored in the memory corresponding to the sixty-four power levels.

Each of the sequences of values represents a ramp-up waveform and a ramp-down waveform corresponding to turn-on and turn-off respectively. One ramp-up waveform can be satisfactorily represented by a sequence of 64 bytes (512 bits) to be stored in the memory and one ramp-down waveform can be satisfactorily represented by a sequence of 64 bytes to be stored in the memory. Thus, the total number of bytes of memory required to store the sixty-four sequences of values is 8192 bytes (65536 bits). This is significantly large particularly when the power control section is integrated in an integrated circuit. An example of this type of amplifier is shown in patent application GB-A-2220808.

It is therefore desirable to reduce the number of bytes of memory required to store all the sequences of values for the different power levels.

In accordance with a first aspect of the invention there is provided a power amplifier being responsive to a power level control signal for amplifying radio frequency signals to define any one of a plurality of amplifier output power envelopes, the power amplifier comprising:
means for generating a predetermined sequence of values that represent a predetermined one of said plurality of amplifier output power envelopes;
means for modifying said sequence of values in response to said power level control signal to provide a modified sequence of values that define a selected output power envelope; and
control means for controlling the amplifier output power in response to the modified sequence of values to amplify the radio frequency signal according to the selected one of said plurality of output power envelopes.

In a preferred embodiment, the modifying means comprises means for clipping the sequence of values at a value which depends on the power level control signal.

In a second embodiment of the invention the modifying means comprises means for multiplying the sequence of values by a scaling factor which depends on the power level control signal.

In a third embodiment of the invention the modifying means comprises combining means for combining a value with the sequence of values. The value depends on the power level control signal and may be a negative number or a positive number bigger than or equal to zero.

The pulsed power amplifier may further comprise a filter such as a low pass filter in order to smooth waveforms generated by the modified sequence of values.

Thus, it will be appreciated that by generating one sequence of values representing one ramp-up and one ramp-down waveform for all the different power levels and using the modification means to modify the values in response to a particular power level, a ramp-up waveform and ramp-down waveform represented by a modified sequence of values can be obtained for any of the power levels and since only one sequence of values need be generated the total number of values is considerably reduced. For the prior art power amplifier described above, for example, only 128 bytes will be required instead of 8192 bytes.

Three pulsed power amplifiers for amplifying radio frequency signals will now be described, by way of example, only with reference to the accompanying drawings in which:
Figure 1 is a block schematic diagram of a first pulsed power amplifier in accordance with the present invention;
Figure 2 is a block schematic diagram of a second pulsed power amplifier in accordance with the present invention;
Figure 3 is a block schematic diagram of a third pulsed power amplifier in accordance with the present invention;
Figure 4 shows a diagrammatic representation of a typical output power versus time response of the pulsed power amplifier shown in Figure 1 during turn-on; and
Figure 5 shows a diagrammatic representation of a typical output power versus time response of the pulsed power amplifier shown in Figure 1 during turn-off.

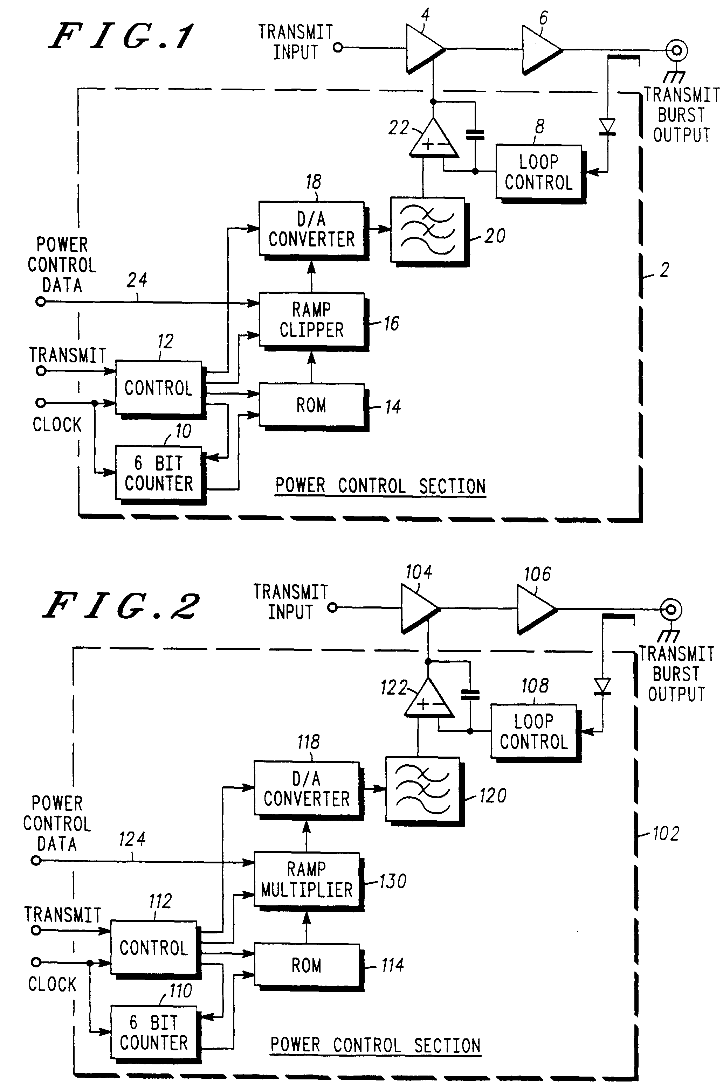

Referring to Figure 1, a power control section 2 is shown coupled to an attenuator 4 which is controlled by a feedback loop 8. An RF signal is supplied to an input of the attenuator 4 whose output is coupled to a RF power amplifier 6. The output of the power amplifier is fed to an antenna (not shown).

The power control section 2 has a clock input CLK coupled to a six-bit counter 10 which is coupled to the address lines of a ROM 14. A control 12, also coupled to the counter 10 and the ROM 14, is controlled by the signal on the clock input CLK and a signal on the transmit input TX. The control 12 is coupled to a ramp clipper 16 and to a digital-to-analog converter 18. ROM 14 provides an eight bit output which is fed to the ramp clipper 16. A ramp clipper is a digital filter device which can be used to place a minimum or maximum value on a digital signal being processed there through. One form of digital clipper is described in patent application CH-A-638935. The ramp clipper 16 is controlled by power control data on a power control data line 24 and its output is fed to the digital-to-analog converter 18, from which the resulting analog signal is fed via a low pass smoothing filter 20 to a comparator amplifier 22 which is coupled to the attenuator 4.

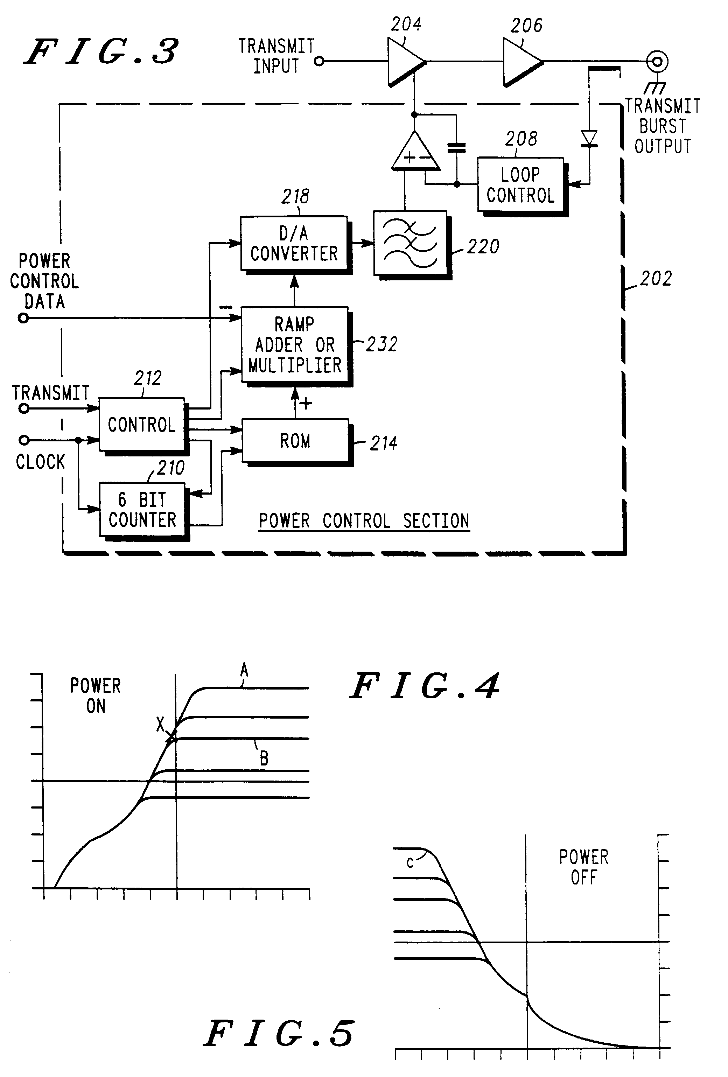

A sequence of values representing one ramp-up and one ramp-down waveform is stored in the ROM 14. Since in the preferred embodiment sixty-four bytes are required to represent a ramp-up waveform, such as the ramp-up waveform A in Figure 4, and sixty-four are required to represent a ramp-down waveform, such as the ramp-down waveform C in Figure 5, the total number of bytes required is 128 bytes. The sequence of values is addressed according to the signal on the address lines coupled to the counter 10.

The operation of the power amplifier in accordance with the invention will now be described. However, since the operation of a power amplifier has been described in detail in the above referenced patent application the operation will not be described in detail.

At the start of transmission of a RF signal, a transmit controller (not shown) selects a power level and sends a corresponding signal on the power control data line 24 to the ramp clipper 16. In addition, the transmit controller (not shown) provides a transmit control signal indicating the start of transmission to the transmit input TX and provides the RF data to be fed to the input of the attenuator 4. On receipt of a 'start' signal at the transmit input TX, under the control of the counter 10 and control 12, the sequence of values representing a ramp-up waveform is read from the ROM 14 and fed to the ramp clipper 16. At the end of the transmission, the transmit controller (not shown) provides an 'end' signal to the transmit input TX whereby, under the control of the counter 10 and control 12, the sequence of values representing the ramp-down waveform C is read from the ROM 14 and fed to the ramp clipper 16.

The power control data signal sent on the power control data line 24 controls the clipping level of the ramp clipper 16. That is, it determines the value in the sequence of values representing a ramp-up waveform to which all the following values in the sequence are clipped. The ramp clipper 16 adds the power control data to the value from the ROM 14 and when this sum exceeds a predetermined threshold, clocking of the digital-to-analog converter 18 is stopped and the last clocked value is continuously output from the digital-to-analog converter. For example, the ramp-up waveform A is clipped above the point X if the power level represented by waveform B is selected. For a ramp-down waveform the signal determines the value in the sequence of values to which all the preceding values in the sequence are clipped. Thus, the ramp clipper 16 in response to the signal on the power control data line 24 clips the sequence of values at a value that depends on the power control data signal in order to obtain ramp-up and ramp-down waveforms which correspond to the selected power level. The output of the ramp clipper is then fed to the analog-to-digital converter 18 to be smoothed by a low pass filter 20. The output power of the power amplifier is thus controlled by the output from the low pass filter which is supplied to the comparator amplifier 22 and the attenuator 4.

The signal on the power control data line 24 is constant during a burst, i.e. during turn-on of the burst modulated power amplifier, and can be changed between bursts so that a different power level is selected for the next burst. It is necessary to have a smoothing low pass filter since the clipping method will produce sharp edges on the ramp-up and ramp-down waveforms. This reduces the spectral noise generated by the power ramping.

The ramp clipper 16 may be replaced by a ramp multiplier 130 as in Figure 2 which shows a second pulsed power amplifier incorporating the invention. Like components to those in Figure 1 are referenced with the same reference numeral plus a hundred. The operation of the second pulsed power amplifier is similar to that of the first described with reference to Figures 1, 4 and 5 except that the ramp-up and ramp-down waveforms for the different power levels are obtained by multiplying the ramp-up and ramp-down waveforms stored in the ROM 114 with a scaling factor. The scaling factor is determined by the signal on the power control data line 124.

Alternatively, the ramp clipper 16 of the first pulsed power amplifier may be replaced by a ramp adder or subtractor 232 as in Figure 3 which shows a third pulsed power amplifier incorporating the invention. Like components to those of Figure 1 are referenced with the same reference numeral plus two hundred. The operation of the third pulsed power amplifier is similar to that of the first described with reference to Figures 1, 4 and 5 except that the ramp-up and ramp-down waveforms for the different power levels are obtained by subtracting a value from the ramp-up and ramp-down waveforms stored in the ROM 214. The value to be subtracted is determined by the signal on the power control data line 224.

It will be appreciated that although it is necessary that a smoothing low pass filter be used with a ramp clipper due to the production of sharp edges on the waveforms, such a low pass filter is not necessarily required for the ramp multiplier and ramp subtractor.

It will also be appreciated that although the preferred embodiments of the invention have been described wherein a sequence of sixty-four values are used to represent one ramp-up waveform and another sequence of sixty-four values are used to represent one ramp-down waveform and each value comprises eight bits, these numbers are arbitrary and may vary with use of the pulsed power amplifier. In addition, the number of desired power levels may vary with use of the pulsed power amplifier.

It will also be appreciated that the time varying signal may also be a single step.

## Claims

1. A method of controlling the output power of a pulsed power amplifier so as to provide an output pulse from the amplifier having a power envelope within a range of power envelopes, wherein there is included the operations of:
generating and storing a single sequence of signal values representative of a desired form of power envelope for an output pulse from the amplifier.
selecting a maximum power level required for the output pulse from the amplifier.
producing an output power level control signal related thereto,
retrieving the stored sequence of signal values representative of the desired form of power envelope for the said output pulse from the amplifier.
operating upon the retrieved sequence of signal values, in response to the power level control signal so as to provide a signal representative of the desired output power pulse envelope and in response thereto,
controlling the output power of the amplifier so as to produce an output pulse having the desired power envelope.

2. A pulsed power amplifier adapted to produce output pulses having power envelopes selected from a range of power envelopes, wherein there is included:
means (114,214,141) for storing a sequence of signal values representative of a predetermined output pulse power envelope,
means (24) for providing a maximum constant power level control signal for a single output pulse from the amplifier,
means (10,12) for retrieving from the store (14) the sequence of signal values representative of the predetermined output pulse power envelope,
means (16, 18, 20, 130, 232) for operating,on the retrieved sequence of signal values retrieved from the store (14), in response to the power level control signal so as to provide a signal representative of the desired output power pulse envelope and
means (4,8 and 22) for controlling the output power of an amplifier (6) to produce the output pulse having the desired power envelope.

3. A pulsed power amplifier according to claim 2 said means for generating a predetermined sequence of values comprises read only memory (14, 114, 214) for storing the predetermined sequence of values and control means (12,112,222).

4. A pulsed power amplifier according to claim 2 or claim 3 wherein said means for providing a constant maximum power level control signal comprises means for clipping (16) said sequence of retrieved signal values at a value which depends on a power level control signal (24).

5. A pulsed power amplifier according to claim 2 or claim 3 wherein said means for providing a constant maximum power level control signal comprises means for multiplying (130) said retrieved sequence of signal values by a value which depends on a power level control signal (124).

6. A pulsed power amplifier according to claim 2 or claim 3 wherein said means providing a constant maximum power level control signal comprises combining means (232) for combining a value with said sequence of retrieved signal values, said value depending on a power level control signal (224).

7. A pulsed power amplifier according to claim 6 wherein said value can be any number bigger than or equal to zero.

8. A pulsed power amplifier according to claim 6 wherein said value can be any negative number.

9. A pulsed power amplifier according to any of the claims 2 to 8 wherein the means for operating on the sequence of retrieved signal values to provide a signal representative of the desired out power pulse envelope includes a digital to analogue converter (18, 118, 218) and a filter (20, 120, 220).

10. A pulsed power amplifier according to any of the claims 2 to 9 wherein the means for controlling the output power of the amplifier (6) comprises a variable attenuator (4, 104, 204) a feed back loop control (810, 8, 708) and a comparator (22, 212, 222).

## Patentansprüche

1. Verfahren der Steuerung der Ausgangsleistung eines gepulsten Leistungsverstärkers, um einen Ausgangsimpuls des Verstärkers bereitzustellen, der eine Leistungshüllkurve innerhalb eines Bereichs von Hüllkurven hat, wobei die folgenden Schritte eingeschlossen sind:
• Erzeugung und Speicherung einer einzelnen Folge von Signalwerten, die typisch für eine gewünschte Form der Leistungshüllkurve für einen Ausgangsimpuls des Verstärkers ist;
• Auswahl eines maximalen Leistungspegels, der für den Ausgangsimpuls des Verstärkers benötigt wird;
• Erzeugung eines Ausgangsleistungspegelsteuersignals, welches sich auf den Ausgangsleistungspegel bezieht;
• Wiedergewinnung der gespeicherten Folge von Signalwerten, die für die gewünschte Form der Leistungshüllkurve für diesen Ausgangsimpuls des Verstärkers typisch ist;
• Betrieb auf Basis der wiedergewonnenen Folge von Signalwerten in Reaktion auf das Leistungspegelsteuerungssignal, um ein Signal bereitzustellen, das für die gewünschte Ausgangsleistungsimpulshüllkurve typisch ist und eine Reaktion auf dieses Leistungspegelsteuerungssignal ist; und
• Steuerung der Ausgangsleistung des Verstärkers, um einen Ausgangsimpuls zu erzeugen, der die gewünschte Leistungshüllkurve hat.

2. Gepulster Leistungsverstärker, der angepaßt ist, Ausgangsimpulse zu erzeugen, die Leistungshüllkurven haben, die aus einem Bereich von Leistungshüllkurven ausgewählt wurden, wobei darin eingeschlossen sind:
• Mittel (114, 214, 141) zur Speicherung einer Folge von Signalwerten, die für eine vorbestimmte Ausgangsimpulsleistungshüllkurve typisch ist;
• Mittel (24) zur Bereitstellung eines maximalen konstanten Leistungspegelsteuerungssignals für einen einzelnen Ausgangsimpuls des Verstärkers;
• Mittel (10, 12) zur Wiedergewinnung der Folge von Signalwerten aus dem Speicher (14), die für die vorbestimmte Ausgangsimpulsleistungshüllkurve typisch ist;
• Mittel (16, 18, 20, 130, 232) zum Betrieb auf der Basis der wiedergewonnenen Folge von Signalwerten, die vom Speicher (14) wiedergewonnen wurde, in Reaktion auf das Leistungspegelsteuerungssignal, um so ein Signal bereitzustellen, das für die gewünschte Ausgangsleistungsimpulshüllkurve typisch ist; und
• Mittel (4, 8 und 22) zur Steuerung der Ausgangsleistung eines Verstärkers (6), um den Ausgangsimpuls zu erzeugen, der die gewünschte Leistungshüllkurve hat.

3. Gepulster Leistungsverstärker nach Anspruch 2, wobei diese Mittel zur Erzeugung einer vorbestimmten Folge von Zahlenwerten einen Nur-Lese-Speicher (14, 114, 214) zur Speicherung der vorbestimmten Folge von Zahlenwerten und Steuerungsmittel (12, 112, 222) umfassen.

4. Gepulster Leistungsverstärker nach Anspruch 2 oder Anspruch 3, wobei diese Mittel zur Bereitstellung eines konstanten maximalen Leistungspegelsteuerungssignals Mittel zur Begrenzung (16) dieser Folge von wiedergewonnenen Signalwerten auf einen Wert umfassen, der von einem Leistungspegelsteuerungssignal (24) abhängt.

5. Gepulster Leistungsverstärker nach Anspruch 2 oder Anspruch 3, wobei diese Mittel zur Bereitstellung eines konstanten maximalen Leistungspegelsteuerungssignals Mittel zur Vervielfachung (130) dieser wiedergewonnenen Folge von Signalwerten um einen Wert umfassen, der von einem Leistungspegelsteuerungssignal (124) abhängt.

6. Gepulster Leistungsverstärker nach Anspruch 2 oder Anspruch 3, wobei diese Mittel, die ein konstantes maximales Leistungspegelsteuerungssignal bereitstellen, Kombinationsmittel (232) zum Kombinieren eines Zahlenwerts mit dieser Folge von wiedergewonnenen Signalwerten umfassen, wobei dieser Zahlenwert von einem Leistungspegelsteuerungssignal (224) abhängt.

7. Gepulster Leistungsverstärker nach Anspruch 6, wobei dieser Zahlenwert jede Zahl größer als oder gleich Null sein kann.

8. Gepulster Leistungsverstärker nach Anspruch 6, wobei dieser Zahlenwert jede negative Zahl sein kann.

9. Gepulster Leistungsverstärker nach einem der Ansprüche 2 bis 8, wobei die Mittel zum Betrieb auf der Basis der Folge von wiedergewonnenen Signalwerten einen Digital-Analog-Wandler (18, 118, 218) und einen Filter (20, 120, 220) umfassen, um ein Signal bereitzustellen, das für die gewünschte Ausgangsleistungsimpulshüllkurve typisch ist.

10. Gepulster Leistungsverstärker nach einem der Ansprüche 2 bis 9, wobei die Mittel zur Steuerung der Ausgangsleistung des Verstärkers (6) ein variables Dämpfungsglied (4, 104, 204), eine Rückkopplungsschleifensteuerung (8, 108, 208) und einen Vergleicher (22, 212, 222) umfassen.

## Revendications

1. Procédé de commande de la puissance de sortie d'un amplificateur de puissance à impulsions de façon à fournir une impulsion de sortie à partir de l'amplificateur présentant une enveloppe de puissance dans un intervalle d'enveloppes de puissance, comprenant les étapes suivantes :
- la génération et le stockage d'une seule séquence de valeurs du signal représentant une forme désirée d'enveloppe de puissance pour une impulsion de sortie de l'amplificateur;
- la sélection d'un niveau de puissance maximum requis pour l'impulsion de sortie de l'amplificateur;
- la production d'un signal de commande de niveau de puissance de sortie correspondant;
- l'extraction de la séquence stockée de valeurs du signal représentant la forme désirée d'enveloppe de puissance pour ladite impulsion de sortie de l'amplificateur;
- l'action sur la séquence extraite de valeurs du signal, en réponse au signal de commande de niveau de puissance, de façon à fournir un signal représentant l'enveloppe désirée d'impulsion de puissance de sortie; et en réponse,
- la commande de la puissance de sortie de l'amplificateur de façon à produire une impulsion de sortie présentant l'enveloppe de puissance désirée.

2. Amplificateur de puissance à impulsions prévu pour produire des impulsions de sortie présentant des enveloppes de puissance sélectionnées à partir d'un intervalle d'enveloppes de puissance, comprenant :
- un moyen (114, 214, 141) pour le stockage d'une séquence de valeurs du signal représentant une enveloppe prédéterminée de puissance d'impulsion de sortie;
- un moyen (24) pour fournir un signal maximum de commande de niveau de puissance constant pour une seule impulsion de sortie de l'amplificateur;
- un moyen (10, 12) pour extraire du stockage (14) la séquence de valeurs du signal représentant l'enveloppe prédéterminée de puissance d'impulsion de sortie;
- un moyen (16, 18, 20, 130, 232) pour agir sur la séquence extraite de valeurs du signal extraites du stockage (14), en réponse au signal de commande de niveau de puissance, de façon à fournir un signal représentant l'enveloppe désirée d'impulsion de puissance de sortie; et
- un moyen (4, 8 et 22) pour la commande de puissance de sortie d'un amplificateur (6) pour produire l'impulsion de sortie ayant l'enveloppe de puissance désirée.

3. Amplificateur de puissance à impulsions selon la revendication 2, dans lequel ledit moyen de génération d'une séquence prédéterminée de valeurs comprend une mémoire morte (14, 114, 214) pour le stockage de la séquence prédéterminée de valeurs et un moyen de commande (12, 112, 222).

4. Amplificateur de puissance à impulsions selon la revendication 2 ou 3, dans lequel ledit moyen fournissant un signal constant de commande de niveau de puissance maximum comprend un moyen pour l'écrêtage (16) de ladite séquence de valeurs extraites du signal à une valeur dépendant d'un signal de commande de niveau de puissance (24).

5. Amplificateur de puissance à impulsions selon la revendication 2 ou 3, dans lequel ledit moyen fournissant un signal constant de commande de niveau de puissance maximum comprend un moyen pour la multiplication (130) de ladite séquence extraite de valeurs du signal par une valeur dépendant d'un signal de commande de niveau de puissance (124).

6. Amplificateur de puissance à impulsions selon la revendication 2 ou 3, dans lequel ledit moyen fournissant un signal constant de commande de niveau de puissance maximum comprend un moyen de combinaison (232) pour combiner une valeur avec ladite séquence de valeurs extraites du signal, ladite valeur dépendant d'un signal de commande de niveau de puissance (224).

7. Amplificateur de puissance à impulsions selon la revendication 6, dans lequel ladite valeur peut être un nombre quelconque supérieur ou égal à zéro.

8. Amplificateur de puissance à impulsions selon la revendication 6, dans lequel ladite valeur peut être un quelconque nombre négatif.

9. Amplificateur de puissance à impulsions selon l'une quelconque des revendications 2 à 8, dans lequel le moyen agissant sur la séquence de valeurs extraites du signal pour fournir un signal représentant l'enveloppe désirée d'impulsion de puissance de sortie comprend un convertisseur digital/analogique (18, 118, 218) et un filtre (20, 120, 220).

10. Amplificateur de puissance à impulsions selon l'une quelconque des revendications 2 à 9, dans lequel le moyen pour la commande de puissance de sortie de l'amplificateur (6) comprend un atténuateur variable (4, 104, 204), une commande à boucle de rétroacticn (810, 8, 708) et un comparateur (22, 212, 222).
